# EUROPÄISCHE PATENTSCHRIFT

(11) **EP 3 596 828 B1**
(45) Veröffentlichungstag und Bekanntmachung des Hinweises auf die Patenterteilung: **16.12.2020**
(21) Anmeldenummer: 18711289.1
(22) Anmeldetag: 12.03.2018
(51) Int. Cl.: H03K 17/96

(54) **VERFAHREN ZUM BESTIMMEN EINES ZEITPUNKTS EINER BERÜHRUNG EINES KAPAZITIVEN SENSORELEMENTS**
METHOD FOR DETERMINING A TIME OF CONTACT ON A CAPACITIVE SENSOR ELEMENT
PROCÉDÉ POUR DÉTERMINER L'INSTANT D'UN EFFLEUREMENT D'UN ÉLÉMENT SENSIBLE CAPACITIF

(30) Priorität: 15.03.2017 DE 102017002482
(43) Veröffentlichungstag der Anmeldung: 22.01.2020
(73) Patentinhaber: KOSTAL Automobil Elektrik GmbH & Co. KG, 58513 Lüdenscheid (DE)
(72) Erfinder: QUINT, Stephan, 66578 Schiffweiler (DE); REBBE, Christoph, 44137 Dortmund (DE); CIOLEK, Phillipp, 45549 Sprockhövel (DE); LEXOW, Carl, Christian, 33520 Bruges (FR)
(74) Vertreter: Kerkmann, Detlef
(86) Internationale Anmeldenummer: PCT/EP2018/056091
(87) Internationale Veröffentlichungsnummer: WO 2018/166976

(56) Entgegenhaltungen:
- EP-A2- 1 505 734
- US-A1- 2004 257 267
- US-A1- 2016 138 941

## Beschreibung

Die Erfindung betrifft ein Verfahren zum Bestimmen eines Zeitpunkts einer Berührung eines kapazitiven Sensorelements, wobei ein Kapazitätswert des Sensorelements fortlaufend gemessen und zu einem digitalen Sensorsignal verarbeitet wird.

Verfahren der hier angesprochenen Art werden verwendet, um kapazitive Berührungs- bzw. Annäherungssensoren auszuwerten. Ein solcher Sensor kann die Gegenwart und bei entsprechender Ausgestaltung auch den Ort einer Berührung oder der Annäherung durch ein Objekt, wie zum Beispiel einen Finger des Benutzers oder einen Stift, innerhalb eines empfindlichen Bereichs detektieren. Der berührungsempfindliche Bereich kann dabei beispielsweise einen Anzeigebildschirm überlagern. In einer Anzeigeanwendung kann es der Berührungs- bzw. Annäherungssensor dem Benutzer ermöglichen, direkt mit dem, was auf dem Bildschirm dargestellt wird, zu interagieren, und nicht nur indirekt mittels einer Maus oder einem ähnlichen Eingabegerät.

Es gibt eine Anzahl verschiedener Arten von Berührungssensoren, wie zum Beispiel resistive Berührungssensoren, Berührungssensoren mit akustischen Oberflächenwellen und kapazitive Berührungssensoren, wobei letztgenannte, mit denen eben insbesondere auch schon eine bloße Annäherung erfasst werden kann, inzwischen die größte Verbreitung erfahren haben.

Wenn ein Objekt die Oberfläche eines kapazitiven Berührungssensors berührt oder in dessen Nähe kommt, tritt eine Änderung des Kapazitätswertes des Sensorelements auf. Aufgabe eines zugeordneten Sensorsteuergerätes bzw. des durch dieses verwendeten Messverfahrens ist es, diese Kapazitätsänderung zu verarbeiten, um die auslösende Berührung oder Annäherung zu erfassen. Die besondere Schwierigkeit hierbei besteht darin, dass die Kapazitätswerte der Sensorelemente und insbesondere die zu erfassenden Änderungen sehr klein sind. Aus diesem Grunde bedient man sich zu ihrer Messung gerne sogenannter Integrationsverfahren, bei denen in mehreren aufeinander folgenden Zyklen kleine Ladungsmengen von dem Sensorelement, dessen Kapazitätswert relativ klein und veränderlich ist, auf einen Integrationskondensator mit einem bekannten festen und deutlich größeren Kapazitätswert übertragen werden. Die an dem Integrationskondensator nach einer vorgegebenen Anzahl solcher Integrationszyklen anliegende Spannung wird dann mittels eines A/D-Wandlers gemessen oder einer Komparator-Schaltung ausgewertet und zu einem digitalen Sensorsignal verarbeitet. Es ist jedoch nicht ausgeschlossen, dass die Kapazitätsänderung auch über andere Verfahren bestimmt werden kann.

Durch die deutsche Offenlegungsschrift DE 10 2010 041 464 A1 ist ein Verfahren zum Erkennen einer Berührung eines kapazitiven Sensorelements bekannt geworden, bei dem ein digitales Sensorsignal, wie zuvor beschrieben, fortlaufend erfasst und mit einem vorgegebenen Signalschwellwert verglichen wird. Solange sich kein Finger bzw. anderes zu erfassendes Objekt dem Sensorelement nähert, verharrt das Sensorsignal auf einem im Wesentlichen konstanten Basiswert. Bei der Annäherung eines Fingers an das Sensorelement steigt das Sensorsignal dagegen deutlich an. Das tatsächliche Erkennen einer Berührung des kapazitiven Sensorelements erfolgt, wenn das Sensorsignal einen zuvor festgelegten Signalschwellwert überschritten hat.

Die US 2016/138941 A1 zeigt ein Verfahren zum Bestimmen eines Zeitpunkts einer Berührung eines kapazitiven Sensorelements gemäß dem Oberbegriff des Patentanspruchs 1. Ein fortlaufend gemessener Kapazitätswert des Sensorelements wird dabei zu einem digitalen Sensorsignal verarbeitet, welches mittels eines digitalen Filters gefiltert wird, und wobei das gefilterte Signal zur Bestimmung des Zeitpunkts mit Schwellwerten verglichen wird.

Tatsächlich ist das Sensorsignal von vielen Parametern abhängig. So haben nicht nur die Form bzw. die Abmessungen des bedienenden Körperteils des Bedieners, also z.B. dünnere oder dickere Finger Einfluss auf dieses Sensorsignal, es spielt etwa auch die Positionierung dieses Körperteils über dem Sensor eine wichtige Rolle. So ist die höchste Empfindlichkeit typischer Weise direkt über dem Schwerpunkt des Sensorelements gegeben und nimmt zum Rand desselben hin ab. Diese Einflüsse können nur in geringem Maße durch die Elastizität der Hautoberfläche bzw. des Fingers ausgeglichen werden.

Ein sicheres Auslösen der mit der Erkennung der Berührung verbundenen Funktion kann bei typischen Anordnungen von Sensorflächen insbesondere im Kraftfahrzeug und der beschriebenen Auswertung über einen zuvor festgelegten Signalschwellwert nicht sichergestellt werden. Eine mögliche Bedienung der sensorischen Funktion mit Handschuhen verschärft das Problem zusätzlich. Bei einer Auslegung des Signalschwellwerts, die eine Bedienung mit Handschuhen ermöglicht, würde bei einer Bedienung ohne Handschuhe bereits mehrere Millimeter über der Sensoroberfläche eine fehlerhafte Erkennung einer vermeintlichen Berührung erfolgen.

Eine ggf. erwünschte aktive haptische Rückmeldung durch eine Aktorik wie etwa einem Hubmagneten, einen Vibrationsmotor oder ähnliches erfordert ebenso eine Berührung der Oberfläche. Dazu muss beim Stand der Technik die kapazitive Sensorik mit einer Kraftsensorik ergänzt werden, was technisch erheblich komplexer und teurer ist.

Das Verfahren gemäß der vorliegenden Erfindung hat gegenüber dem zuvor beschriebenen den Vorteil, nicht nur generell die Erkennung einer Berührung des kapazitiven Sensorelements zu ermöglichen, sondern mit hoher Genauigkeit und hohem Signal-zu-Rausch-Gewinn auch den Zeitpunkt dieser Berührung zu ermitteln. Damit ist nicht nur die Erkennung einer Berührung des Sensorelements praktisch unabhängig von den geschilderten Einflussparametern wie Größe, Form und Positionierung des Fingers oder sogar unterschiedlich dicke Handschuhe sichergestellt, sondern auch eine praktisch verzögerungsfreie Auslösung der mit der Berührung beabsichtigten Aktion.
Dies gelingt erfindungsgemäß durch ein Verfahren mit den Merkmalen des Patentanspruchs 1

Dabei erfolgt zunächst eine Filterung des Sensorsignals am besten mittels eines digitalen Filters, bevorzugt eines FIR-Filters, welches eine Flankendetektion in Form einer Pulskompression bei gleichzeitiger Offset-Eliminierung ausführt und ein Filtersignal ausgibt. Dieses Filtersignal weist in Abhängigkeit des Signalverlaufs und des überlagerten Rauschens Minima und Maxima auf, wobei sich die Annährung des Fingers durch ein ansteigendes Filtersignal ausgedrückt, bis es unmittelbar vor dem Zeitpunkt des Aufsetzens zu einem Maximalwert des Filtersignals kommt. Der Amplitudenwert eines solchen Maximums liegt deutlich höher als solche, die etwa durch Rauschen verursacht werden. Erfindungsgemäß wird ein Anstieg des Filtersignals daher als beginnende Signaldynamik gewertet, wenn es einen ersten Filter-Schwellwert überschreitet.

Nachdem eine beginnende Dynamik festgestellt wurde, wird ein lokales, oder besser noch globales Maximum des Filtersignals als maximale Dynamik ermittelt, und ein zweiter Filter-Schwellwert, bevorzugt ein temporärer zweiter Filter-Schwellwert als Prozentsatz des Wertes des Maximums des Filtersignals festgelegt oder auf einen festen, vorher fest definierten zweiten Schwellwert zurück gegriffen.

Der Zeitpunkt, zu dem das Filtersignal den zweiten temporären oder festen Filter-Schwellwert unterschreitet, wird dann als Zeitpunkt der Berührung des kapazitiven Sensorelements ausgegeben, wenn der Hub des durch die Berührung zustande gekommenen Sensorsignals einen vorher definierten Sensorsignal-Schwellwert überschreitet. Dieser Sensorsignal-Schwellwert muss so gewählt sein, dass er einerseits den Signaloffset, d.h. den Wert des Sensorsignals vor der Berührung, als virtuelle Nulllinie berücksichtigt. Andererseits, muss er so gewählt werden, dass er zusätzlich ausreichenden Abstand zu additivem Rauschen hat.

Der Signaloffset ist in der Regel jedoch nicht konstant und hängt signifikant von äußeren Parametern wie der Temperatur ab. So würde sich ein vorher definierter fester Sensorsignal-Schwellwert relativ zum Signaloffset als virtuelle Nulllinie verschieben, wenn die Drift des Signaloffsets nicht berücksichtigt wird. Um Auswirkungen auf die Berührerkennung zu vermeiden, ist es daher von großer Bedeutung, die Einflüsse eines zeitlich nicht konstanten Signaloffsets zu minimieren oder gar zu eliminieren, indem er vom Sensorsignal fortlaufend subtrahiert wird.

Das Filtersignal besitzt die Eigenschaft, dass seine zeitliche Integration in einer offsetfreien Rekonstruktion des Verlaufs bzw. Hubs des Sensorsignals resultiert. Eine aktive Driftkompensation einer etwa durch Temperaturschwankungen hervorgerufenen Signaldrift durch einen Regelkreis mit verhältnismäßig großer Zeitkonstante erzeugt aus dem rekonstruierten Sensorsignal ein Fehlersignal, das auch zur weiteren Signalbewertung dient. Wenn das Filtersignal einen ersten festgelegten Filter-Schwellwert überschreitet, wird eine beginnende Dynamik festgestellt, und die Driftkompensation des rekonstruierten Sensorsignals abgeschaltet.

Der Zeitpunkt, zu dem das Filtersignal den zweiten temporären oder festen Filter-Schwellwert unterschreitet, wird dann als Zeitpunkt der Berührung des kapazitiven Sensorelements ausgegeben, wenn das Fehlersignal der Driftkompensation als Maß des drift- und offsetfreien, rekonstruierten Sensorsignals zu diesem Zeitpunkt über einem festgelegten Sensorsignal-Minimalwert liegt der einen ausreichenden Abstand zum Rauschen besitzt.

Nach der Ausgabe eines Zeitpunkts der Berührung des kapazitiven Sensorelements wird eine erneute Ausgabe eines solchen Zeitpunkts gesperrt, bis der Abschluss der gerade ausgegebenen Berührung erkannt wurde. Dazu wird ein zweiter Sensorsignal-Schwellwertes bevorzugt als Prozentsatz des Maximalwertes des drift- und offsetfreien, rekonstruierten Sensorsignals festgelegt, und der Abschluss der Berührung erkannt, wenn dieses rekonstruierte Sensorsignal den zweiten festgelegten Sensorsignal-Schwellwert unterschreitet. Nachdem der Abschluss der Berührung erkannt wurde, wird das gesamte System für eine neue Erkennung freigeschaltet.

Durch die erfindungsgemäße Filterung des Sensorsignals bevorzugt mittels eines FIR-Filters kann das zeitliche Verhalten des Sensorsignals bei einer Annäherung oder Berührung des Sensorelements betrachtet werden. Das Filtersignal, als Ergebnis der durchgeführten Pulskompression, gibt in seinem zeitlichen Verlauf das dynamische Verhalten des Sensorsignals wieder, verbessert gleichzeitig das Signal-zu-Rausch-Verhältnis, wodurch auch schwache Amplituden, beispielsweise bedingt durch Handschuh-Betätigung, zuverlässig erkannt werden können.

Bei der Annäherung eines Fingers oder eines anderen Körperteils an das Sensorelement aus größerer Entfernung wird das Sensorsignal stetig größer. Bei der Berührung des Sensorelements wird der Finger dann abgebremst und im Rahmen seiner Elastizität verformt. Dieser Ablauf spiegelt sich im zeitlichen Verhalten des Sensorsignals dergestalt wider, dass dieses zunächst deutlich langsamer steigt und beim vollständigen Aufliegen des Fingers dann nahezu konstant bleibt. Dieses Verhalten ist qualitativ weitgehend unabhängig von der Größe des Fingers, der Positionierung des Fingers auf der Sensorfläche und davon, ob Handschuhe genutzt werden oder nicht.

Unabhängig von der Signalcharakteristik können Betätigungen sehr schnell oder sehr langsam erfolgen, sodass ein weiter Dynamikbereich abgedeckt werden muss. Dies geschieht erfindungsgemäß durch mehrere Signal-Auswerte-Pfade, die sich in ihren Dynamikbereichen überlappen und im Wesentlichen unterschiedlich schnell und unterschiedlich empfindlich auf eine Berührung reagieren. Während die Abtastrate des ursprünglichen Sensorsignals geeignet ist, um der höchsten Dynamik zu begegnen, wird dieses Signal genutzt, denjenigen Pfad zu versorgen, der die höchste Bandbreite aufweist.

Dazu wird in einer Weiterbildung des erfindungsgemäßen Verfahrens das fortlaufend ermittelte, ursprüngliche Sensorsignal durch Mittelung über mehrere aufeinanderfolgende Werte heruntergetaktet. Bei dieser auch als ,Downsampling' bezeichneten Vorgehensweise werden die einzelnen Signalwerte mit gleichen oder unterschiedlich gewählten Gewichtungsfaktoren gemittelt. In Abhängigkeit der Zahl an Downsampling-Stufen ergeben sich weitere Signalzweige, die in folgenden Signalverarbeitungsschritten je eine andere Signaldynamik adressieren, in denen die Sensorsignale aber die gleichen, bereits zuvor näher erläuterten Verfahrensschritte durchlaufen.

Das erfindungsgemäße Verfahren macht sich unter anderem die Erkenntnis zu Nutze, dass es zur Beherrschung der vorhandenen quantitativen Unterschiede im zeitlichen Verlauf des Sensorsignals in der Regel ausreichend ist, ein Auswerteverfahren parallel in lediglich zwei Verfahrenszweigen mit jeweils unterschiedlichen Zeitskalen auszuführen. Dazu wird das fortlaufend ermittelte Sensorsignal durch Mittelung über mehrere, vorzugsweise vier, aufeinanderfolgende Werte zu einem zweiten Sensorsignal heruntergetaktet.

Sowohl das ursprüngliche, erste Sensorsignal als auch das heruntergetaktete, zweite Sensorsignal durchlaufen dann in parallel zueinander ausgeführten Verfahrenszweigen jeweils die weiteren Verfahrensschritte, die auf die Feststellung des universellen, qualitativen Verlaufs des Sensorsignals abzielen. Wenn dabei in einem der beiden Zweige das für eine Berührung des Sensorelements charakteristische Verhalten festgestellt wird, wird der ermittelte Zeitpunkt der Berührung ausgegeben.

Aufgrund der Gruppenlaufzeit linearer Systeme, die mit der effektiven Zahl an Speicherzellen (,Delay-Blöcken') zunimmt, wird derjenige Pfad, der die höchste Signaldynamik auswertet, immer als erstes reagieren, da er, bezogen auf die initiale Zeitbasis, der zeitlich kürzeste ist. Die Reaktionszeit folgender Pfade verlängert sich in Abhängigkeit der effektiven Zeitbasis, die sich durch das Heruntertakten ergibt. Derjenige Pfad, der bezogen auf die initiale Taktrate, die größte Teilung erfährt, wird somit als letztes auslösen.

Diese intrinsische Verzögerung wird erfindungsgemäß genutzt, um im Falle einer Auslösung denjenigen Pfad zu bevorzugen, der die höchste Signaldynamik, d.h. die schnellste Betätigung auflöst, indem, sobald eine Betätigung erkannt wurde, alle anderen Pfade für eine Auslösung gesperrt werden. Somit werden doppelte oder mehrfache Auslöser bei einer einzigen Betätigung vermieden.

Eine Rücksetzung und erneute Freigabe des gesamten Systems, insbesondere der Freigabe aller Regler erfolgt dann, wenn der Abschluss der Betätigung erkannt wird. Dies kann (muss jedoch nicht) dann geschehen, wenn der Kanal der geringsten Dynamik den Abschluss der Betätigung erkennt. Diese Erkennung basiert auf einer erneuten Diskriminierung des Fehlersignals der Regler-Stufe, das dem drift- und offsetfreien Sensorsignal entspricht. Der benötigte Schwellwert berechnet sich aus einem prozentualen Anteil der maximalen Amplitude des Fehlersignals, die während der Betätigung auftritt. Fällt das Fehlersignal unter diese Schwelle, bedeutet dies den Abschluss der Betätigung und das GesamtSystem wird für eine neue Erkennung frei gegeben.

Nachfolgend ist das erfindungsgemäße Verfahren unter Bezugnahme auf die in der beigefügten Zeichnung wiedergegebenen Flussdiagramme erläutert.

Dabei zeigen:
- **Fig. 1:**: den zeitlichen Ablauf des erfindungsgemäßen Verfahrens von der A/D-Wandlung des Sensorsignals bis zum Start der nächsten Messung
- **Fig. 2:**: eine Detaillierung des in Fig. 1 mit den Blocks "Fig. 2" bezeichneten, beiden Verfahrenszweigen gemeinsamen Teils des zeitlichen Ablaufs

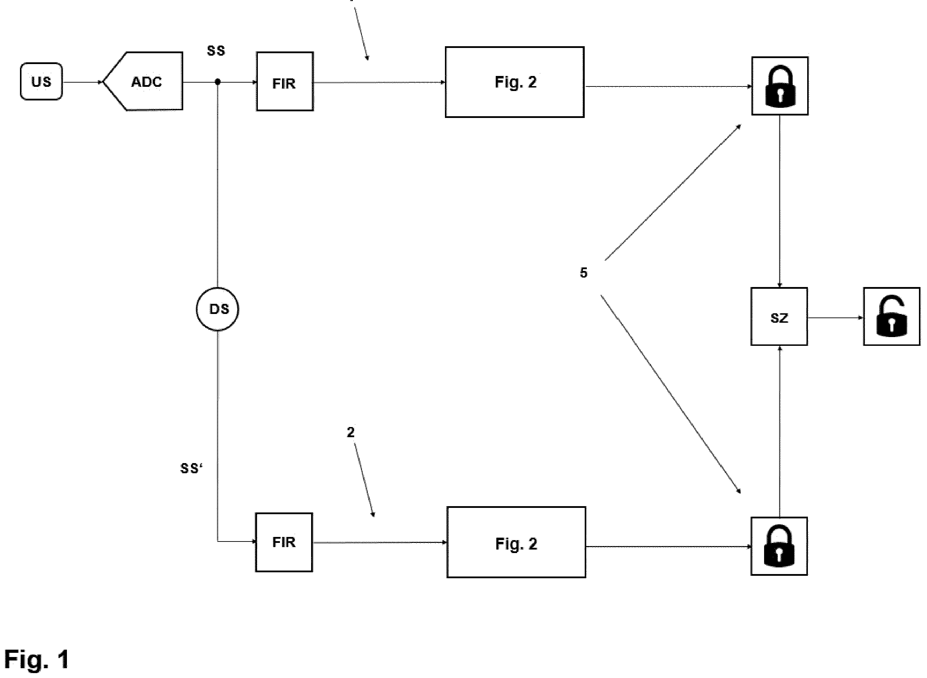

Wie die Zeichnung in Fig. 1 zeigt, werden die mittels des fortlaufend angewendeten Integrationsverfahrens gemessenen analogen Spannungswerte US im konkreten Beispiel mit einer Rate von 500 Werten pro Sekunde (SPS) einem A/D-Wandler ADC zugeführt und dort zu einem digitalen Sensorsignal SS der gleichen Rate verarbeitet. Das Signal kann aber auch auf anderen Wegen gewonnen werden, wie z.B. durch Wägeverfahren, Impedanzmessung allgemein, Frequenzantwort oder andere. Auch die initiale Sample-Rate kann abweichend von 500SPS gewählt werden, solange der gesamte geforderte Dynamikbereich berücksichtigt wird.

Dieses digitale Sensorsignal SS wird dann als erstes Sensorsignal SS direkt einem ersten Verfahrenszweig 1 zugeleitet. Parallel dazu wird das Sensorsignal SS in einer Heruntertaktungs-Einheit DS durch Bildung eines gleitenden Durchschnitts über mehrere aufeinanderfolgende Werte zu einem zweiten Sensorsignal SS' verarbeitet und dann einem zweiten Verfahrenszweig 2 zugeführt.

Das ursprüngliche, erste Sensorsignal SS und das heruntergetaktete, zweite Sensorsignal SS' werden dann in den parallel ausgeführten ersten und zweiten Verfahrenszweigen 1, 2 jeweils mittels eines FIR-Filters FIR einer Pulskompression unterzogen. Dabei werden die Werte des Sensorsignals SS, SS' zunächst in einem Ringspeicher (FIFO) gespeichert. Der Speicherumfang bzw. die Speicherlänge entspricht im Idealfall genau der zeitlichen Länge einer zu erkennenden Signalflanke. Mit jedem neuen Wert des Sensorsignals SS, SS' wird aus dem Ringspeicher der älteste Wert gelöscht, sodass eine quasikontinuierliche Bewertung der gesamten Signalflanke erfolgen kann.

Alle Werte des Sensorsignals SS, SS' in den Speicherzellen des Ringspeichers werden dann mit einem Satz von Gewichtungsfaktoren multipliziert und die Multiplikationsergebnisse aufsummiert. Dieses Verfahren wird auch als zeitdiskrete Faltung oder Korrelation bezeichnet, das resultierende Ausgangssignal des FIR-Filters FIR fortan als Filtersignal FS, FS'. Die Gewichtungsfaktoren können so gewählt werden, dass im Falle einer vollständig eingelaufenen Signalflanke ein maximales Filtersignal FS, FS' entsteht, im Falle einer nicht vollständig eingelaufenen Flanke hingegen ein Filtersignal FS, FS', das sich von Null kaum unterscheidet.

Bei der Wahl der Gewichtungsfaktoren muss der kleinste gemeinsame Nenner zwischen verschiedenen Flankenverläufen und Flankenlängen gefunden werden. Gemeinsamkeiten zwischen verschiedenen Flankenverläufen bestehen darin, dass jede Flanke einen Wendepunkt besitzt. Da der Flankenverlauf vor und nach dem Wendepunkt unterschiedlich sein kann, wird im konkreten Beispiel ein Satz an Gewichtungsfaktoren gewählt, die +1 und -1 und gegebenfalls 0 entsprechen. Dabei wird die zuerst in das Filter FIR eingelaufene Hälfte der Werte des Sensorsignals mit -1, die danach eingelaufene Hälfte der Werte mit +1 multipliziert. Die Werte können sich jedoch durchaus von +/-1 unterscheiden, und die Polarität des resultierenden Signals kann ebenfalls frei gewählt werden.

Als Länge des Filters FIR, sprich als Anzahl der Speicherzellen des Ringspeichers, wurde im vorliegenden Ausführungsbeispiel der Wert "12" gewählt. Diese Filterlänge bringt im Zusammenhang mit der gewählten Abtastrate des Sensorsignals von 500 Werten pro Sekunde für die in einem Probandentest durchgeführten Bedienungen die beste Erkennungsleistung. Das durch die so beschaffenen FIR-Filter in beiden Verfahrenszweigen 1, 2 jeweils ausgegebene Filtersignal FS, FS' entspricht dann im Wesentlichen einer zeitdiskreten Ableitung des geglätteten Eingangssignals des Filters FIR. Da mit der Filterung zwar eine Bandbreitenreduktion einhergeht, an dieser Stelle jedoch kein Heruntertakten vorgenommen wird, ist das resultierende Signal relativ zur Bandbreite überabgetastet, sodass die zeitliche Auflösung des Sensorsignals beibehalten wird.

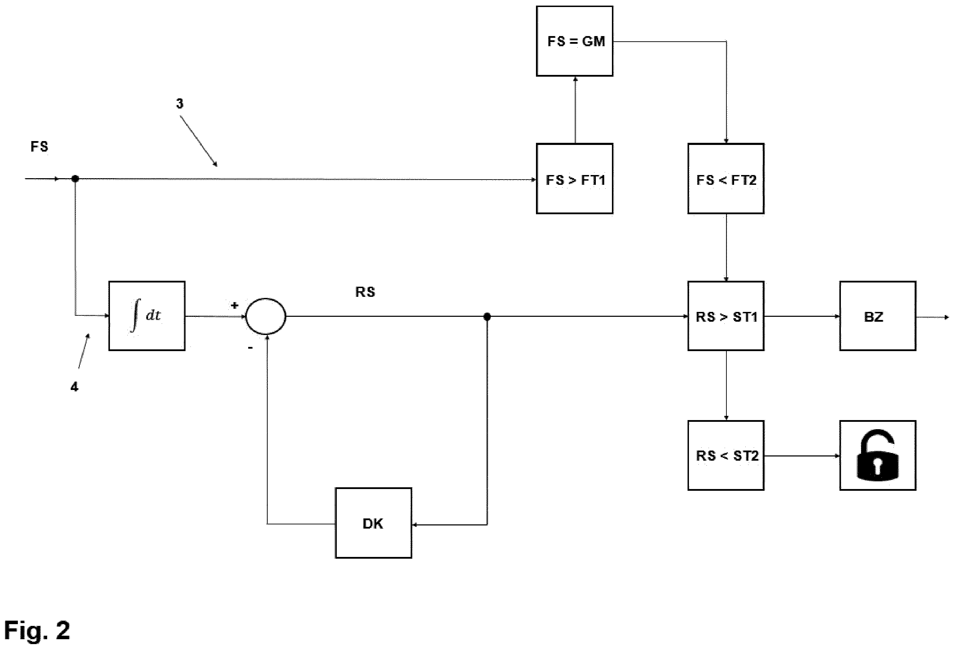

Die folgenden, in beiden Verfahrenszweigen 1, 2 identischen Verfahrensschritte werden weiter anhand der Fig. 2 beschrieben. Dabei wird auf die Unterscheidung der Sensor- und Filtersignale SS, SS' bzw. FS, FS' der Zweige 1, 2 verzichtet und im Folgenden nur noch die Bezugszeichen SS und FS verwendet.

In jedem der beiden Verfahrenszweige 1,2 wird das Filtersignal FS in wiederum zwei parallel zueinander verlaufenden Zweigen einerseits einem Dynamikauswertungspfad 3 und andererseits einem Kontrollpfad 4 zugeführt.

In dem Dynamikauswertungspfad 3 wird das Filtersignal FS mit einem ersten festgelegten Filter-Schwellwert FT1 verglichen. Wenn das Filtersignal FS diesen ersten Filter-Schwellwert FT1 überschreitet, wird eine beginnende Dynamik festgestellt. Es ist zu beachten, dass FT1 Null entsprechen kann und somit auch Dynamiken ausgewertet werden, die im Rauschen liegen. Dies erfordert zwar mehr Rechenleistung, jedoch wird das Verfahren dadurch nicht beeinflusst.

Mit der Feststellung einer beginnenden Dynamik wird eine Abtastung des Filtersignals FS auf die Ausbildung eines globalen Maximums GM eingeleitet. Sobald das Filtersignal FS ein solches globales Maximum GM ausgebildet hat, wird der Wert dieses globalen Maximums GM zur Definition eines zweiten Filter-Schwellwerts FT2 verwendet. In dem gezeigten Ausführungsbeispiel wird die Größe dieses zweiten Filter-Schwellwerts FT2 auf 25% des Wertes des globalen Maximums GM festgelegt. Über den prozentualen Wert des zweiten Schwellwertes FT2 kann direkt Einfluss auf den Zeitpunkt der Berührung genommen werden. Wird der Wert beispielsweise auf 50% des Maximalwertes definiert, so findet ein Auslösen zeitlich früher statt. Dieser Effekt kann dazu genutzt werden, die Gruppenlaufzeit des Signals durch das System zu kompensieren, sodass der Anwender praktisch keinerlei Auslöse-Verzögerung wahrnimmt. Dies kommt vor allem der Anforderung vieler OEMs entgegen, die sehr kleine Latenzen im Millisekundenbereich (<50ms) fordern. Wählt man diesen Wert jedoch zu hoch, kann es passieren, dass lokale Maxima auf der Flanke bereits zum Auslösen führen. Ein Wert von 25% (1/4) hat sich daher, im Rahmen der Latenz-Anforderungen und auch im Rahmen der Möglichkeiten der Signalverarbeitung auf leistungsschwachen Mikrocontrollern als günstig erwiesen.

Die Filter FIR in den beiden Verfahrenszweigen 1, 2 sind so gewählt, dass das Filtersignal FS immer dann seinen maximalen Wert annimmt, wenn die Signalflanke vollständig eingelaufen ist, d.h. wenn sich der Wendepunkt des Sensorsignals genau in der Mitte des Filters befindet. Würde man also das Maximum des Filtersignals FS, also die steigende Flanke des Sensorsignals SS genau ermitteln, wüsste man den Zeitpunkt, bei dem das Sensorsignal SS zu einem Plateau übergeht. Dies ist praktisch jedoch schwierig zu ermitteln, da auf dem Dynamiksignal lokale Maxima bedingt durch den Flankenverlauf liegen können. Daher wird das globale Maximum GM des Filtersignals FS abgewartet und anhand dessen ein dynamischer Schwellwert FT2 ermittelt, unter den das Filtersignal FS fallen muss, bevor die Berührungserkennung ausgelöst wird.

Zur Bestimmung des Zeitpunkts der Berührung des Sensorelements wird daher zunächst der Zeitpunkt bestimmt, zu dem das Filtersignal FS den zweiten Filter-Schwellwert FT2 unterschreitet.
Da das Dynamiksignal sehr anfällig gegenüber schnellen Amplitudenänderungen ist, wie sie z.B. durch ein Zittern hervorgerufen werden können, ist es unbedingt notwendig, zum potenziellen Auslösezeitpunkt den Hub des ursprünglichen Sensorsignals SS relativ zu seinem Signal-Offset zu bewerten, der ein Kriterium für den Abstand des Fingers/Körperteils zur Sensoroberfläche ist.

Dazu wird in dem parallel verlaufenden Kontrollpfad 4 durch kontinuierliche zeitliche Integration des Filtersignals FS der ursprüngliche Verlauf des Sensorsignals SS, also des Eingangssignals des FIR-Filters FIR wieder rekonstruiert. Dieses rekonstruierte Sensorsignal RS ist offsetfrei, d.h. seine Basislinie ist eine Nulllinie. Bevor der Rekonstruktions-Mechanismus im jeweiligen Pfad initial aktiv geschaltet wird, muss eine gewisse Zeit abgewartet werden, bis das System, insbesondere die Downsampling-Stufen DS und der Pulskompressionsfilter FIR, eingeschwungen sind, um zu vermeiden, dass durch die Integration der Filterantwort auf die Einschaltfunktion (Stufenfunktion) auch der Systemoffset dauerhaft rekonstruiert wird.

Der Signalhub des Sensorsignals SS kann so sofort als Höhe des rekonstruierten Sensorsignals RS abgelesen und mit einem weiteren Schwellwert ST1 verglichen werden. Dieser Sensorsignal-Minimalwert ST1 muss systembedingt angepasst werden, kann jedoch sehr klein gewählt werden.

Wird der Sensorsignal-Minimalwert ST1 zu klein gewählt, kann es passieren, dass das Sensorsignal SS diesen bereits aufgrund thermischer Drift überschreitet. Daher ist sicherzustellen, dass eine Temperatur-Drift des rekonstruierten Sensorsignals RS den Auswerte-Mechanismus nicht beeinflusst. Dazu wird das rekonstruierte Sensorsignal RS in einem Regelkreis DK zur Driftkompensation, der hier nur aus einem Integrator besteht, mit verhältnismäßig kleinem Gain-Faktor immer wieder auf die Nulllinie gezogen. Bei der zuvor beschriebenen Feststellung einer beginnenden Dynamik wird dieser Regelungs-Mechanismus DK außer Kraft gesetzt, um eine mögliche Berührungserkennung vor allem bei sehr langsamen Annäherungen nicht auszuregeln. Ist die Betätigung vorüber, wird der Regelkreis DK wieder freigegeben. Die Bandbreite des Regelkreises DK ist dabei viel kleiner als die Bandbreite, die sich bei Tastenbetätigungen ergibt. Somit stehen sich beide Dynamiken nicht im Wege.

Wenn das drift- und offsetfreie, rekonstruierte Sensorsignals RS über dem festgelegten Sensorsignal-Minimalwert ST1 liegt, wird der Zeitpunkt, zu dem das Filtersignal FS den zweiten temporären Filter-Schwellwert FS2 unterschreitet, als Zeitpunkt der Berührung BZ des kapazitiven Sensorelements ausgegeben.

Um Mehrfachauslösungen zu vermeiden, ist das Gesamtsystem zusätzlich mit einem sogenannten "System-Lock"-Mechanismus 5 versehen. Dieser bewirkt im Fall der gültigen Ausgabe eines Berührungszeitpunkts BZ des Sensorelements in einem der beiden Verfahrenszweige 1, 2, dass die Detektion auf dem jeweils anderen Verfahrenszweig für eine Sperrzeit SZ unterbunden wird. Erst wenn die Sperrzeit SZ abgelaufen, oder eine erkannte Betätigung vorüber ist, d.h. der Finger wieder von dem Sensorelement entfernt ist, wird das Gesamtsystem für weitere Erkennungen freigegeben.

Zur Erkennung des Abschlusses der gerade ausgegebenen Berührung wird ein Sensorsignal-Schwellwert ST2 als fester Wert oder als Prozentsatz des Maximalwertes des drift- und offsetfreien, rekonstruierten Sensorsignals RS festgelegt, und der Abschluss der Berührung erkannt, wenn dieses rekonstruierte Sensorsignal RS den festgelegten Sensorsignal-Schwellwert ST2 unterschreitet. Nachdem so der Abschluss der Berührung erkannt wurde, wird das gesamte System für eine neue Erkennung freigeschaltet.

## Patentansprüche

1. Verfahren zum Bestimmen eines Zeitpunkts einer Berührung eines kapazitiven Sensorelements, wobei ein Kapazitätswert des Sensorelements fortlaufend gemessen und zu einem digitalen Sensorsignal (SS) verarbeitet wird, wobei das fortlaufend ermittelte Sensorsignal (SS) die folgenden Verfahrensschritte durchläuft:
- Filterung des Sensorsignals (SS) mittels eines digitalen Filters, bevorzugt eines FIR-Filters (FIR), das ein Hochpass- oder Bandpass- Verhalten zeigt und ein Filtersignal (FS) ausgibt
- Feststellen einer beginnenden Dynamik, wenn das Filtersignal (FS) einen ersten festgelegten Filter-Schwellwert (FT1) überschreitet
- Bestimmung des Zeitpunktes, zu dem das Filtersignal (FS) einen zweiten festgelegten Filter-Schwellwert (FT2) unterschreitet als potentiellen Zeitpunkt der Berührung.
- Ausgabe des bestimmten potentiellen Zeitpunktes der Berührung als tatsächlichen Zeitpunkt der Berührung (BZ) des kapazitiven Sensorelements, wenn das Sensorsignal (SS) bezüglich seines Wertes vor der Berührung, der als virtuelle Nulllinie berücksichtigt wird, einen Sensorsignal-Schwellwert (ST1) überschreitet, **dadurch gekennzeichnet, dass** das Filtersignal (FS) zur offsetfreien Rekonstruktion (RS) des Verlaufs des Sensorsignals (SS) fortlaufend integriert wird, und dass der bestimmte potentielle Zeitpunkt der Berührung als tatsächlicher Zeitpunkt der Berührung (BZ) ausgegeben wird, wenn das rekonstruierte Sensorsignal (RS) zu diesem Zeitpunkt über dem Sensorsignal-Schwellwert (ST1) liegt.

2. Verfahren nach Anspruch 1, **dadurch gekennzeichnet, dass** das fortlaufend ermittelte, erste Sensorsignal (SS) durch Mittelung über mehrere aufeinanderfolgende Werte zu zumindest einem weiteren Sensorsignal (SS') heruntergetaktet wird, und dass das ursprüngliche, erste Sensorsignal (SS) und das zumindest eine heruntergetaktete, weitere Sensorsignal (SS') in parallel ausgeführten Verfahrenszweigen (1, 2) jeweils die gleichen Verfahrensschritte durchlaufen.

3. Verfahren nach Anspruch 1 oder 2, **dadurch gekennzeichnet, dass** eine Driftkompensation des rekonstruierten Sensorsignals (RS) über einen Regler-Mechanismus erfolgt, der initial den Einschwingvorgang des FIR-Filters (FIR) abwartet, und dass die Driftkompensation temporär abgeschaltet wird, wenn eine beginnende Dynamik festgestellt wurde.

4. Verfahren nach einem der Ansprüche 1 bis 3, **dadurch gekennzeichnet, dass** die Ausgabe eines weiteren Zeitpunkts der Berührung (BZ) des kapazitiven Sensorelements bis zum Abschluss der Berührung gesperrt wird, und dass der Abschluss der Berührung erkannt wird, wenn das rekonstruierte Sensorsignal (RS) einen in Abhängigkeit eines Maximalwertes des rekonstruierten Sensorsignals (RS) festgelegten Sensorsignal-Schwellwert (ST2) unterschreitet.

5. Verfahren nach einem der Ansprüche 2 bis 4, **dadurch gekennzeichnet, dass** nach der Ausgabe eines Zeitpunkts der Berührung (BZ) des kapazitiven Sensorelements in weiteren Verfahrenszweigen (1, 2) weitere Ausgaben/Auslöser für eine Sperrzeit (SZ) unterbunden werden.

6. Verfahren nach Anspruch 5, **dadurch gekennzeichnet, dass** die Sperrzeit (SZ) beendet wird, wenn einer der beiden Verfahrenszweige (1, 2) einen Abschluss der Berührung erkannt hat.

7. Verfahren nach einem der Ansprüche 1 bis 6, **dadurch gekennzeichnet, dass** der Kapazitätswert des Sensorelements mittels eines fortlaufend angewendeten Integrationsverfahrens gemessen wird, bei dem jeweils eine an einem Integrationskondensator mit einem bekannten Kapazitätswert anliegende Spannung (US) mittels eines A/D-Wandlers (ADC) gemessen und zu einem digitalen Sensorsignal (SS) verarbeitet wird.

8. Verfahren nach einem der Ansprüche 1 bis 7, **dadurch gekennzeichnet, dass** der erste festgelegte Filter-Schwellwert (FT1) zu Null gesetzt wird.

9. Verfahren nach einem der Ansprüche 1 bis 8 **dadurch gekennzeichnet, dass** der zweite festgelegte Filter-Schwellwert (FT2) im Falle einer Berührung als entweder prozentualer Wert eines gefundenen Filtersignal-Maximums dynamisch errechnet oder konstant gewählt wird.

10. Verfahren nach einem der Ansprüche 1 bis 9, **dadurch gekennzeichnet, dass** die Filterung des Sensorsignals (SS, SS') mittels des FIR-Filters (FIR) erfolgt, indem die Werte des Sensorsignals (SS, SS') in den Speicherzellen eines Ringspeichers gespeichert und mit einem Satz von Gewichtungsfaktoren multipliziert werden, und dann die Multiplikationsergebnisse aufsummiert werden.

## Claims

1. Method for determining an instant of contact of a capacitive sensor element, wherein a capacitance value of the sensor element is continuously measured and processed to a digital sensor signal (SS), wherein the continuously determined sensor signal (SS) passes through the following method steps:
- Filtering of the sensor signal (SS) by means of a digital filter, preferably an FIR filter (FIR), which exhibits a high-pass or band-pass behaviour and outputs a filter signal
- Detection of a beginning dynamic when the filter signal (FS) exceeds a first defined filter threshold (FT1)
- Determination of the time at which the filter signal (FS) falls below a second defined filter threshold value (FT2) as the potential time of contact,
- Output of the determined potential time of contact as actual time of contact (BZ) of the capacitive sensor element, if the sensor signal (SS) exceeds a sensor signal threshold value (ST1) with respect to its value before contact, which is taken into account as a virtual zero line,
**characterized in that** the filter signal (FS) is continuously integrated for offset-free reconstruction (RS) of the course of the sensor signal (SS), and **in that** the determined potential time of the contact is output as the actual time of the contact (BZ) if the reconstructed sensor signal (RS) is above the sensor signal threshold value (ST1) at this time.

2. Method according to claim 1, **characterized in that** the continuously determined first sensor signal (SS) is clocked down to at least one further sensor signal (SS') by averaging over a plurality of successive values, and **in that** the original first sensor signal (SS) and the at least one clocked down further sensor signal (SS') in parallel method branches (1, 2) each pass through the same method steps.

3. Method according to claim 1 or 2, **characterized in that** drift compensation of the reconstructed sensor signal (RS) is carried out via a controller mechanism which initially waits for the transient response of the FIR filter (FIR), and **in that** the drift compensation is temporarily switched off when an incipient dynamic has been detected.

4. Method according to one of claims 1 to 3, **characterized in that** the output of a further instant of contact (BZ) of the capacitive sensor element is blocked until the contact is terminated, and **in that** the termination of the contact is detected when the reconstructed sensor signal (RS) falls below a sensor signal threshold value (ST2) determined as a function of a maximum value of the reconstructed sensor signal (RS).

5. Method according to one of claims 2 to 4, **characterized in that** after the output of a moment of contact (BZ) of the capacitive sensor element in further process branches (1, 2) further outputs/triggers are inhibited for a blocking time (SZ).

6. Method according to claim 5, **characterized in that** the blocking period (SZ) is terminated when one of the two branches of the method (1, 2) has detected a termination of the contact.

7. Method according to one of claims 1 to 6, **characterized in that** the capacitance value of the sensor element is measured by means of a continuously applied integration method, in which in each case a voltage (US) applied to an integration capacitor with a known capacitance value is measured by means of an A/D converter (ADC) and processed to form a digital sensor signal (SS).

8. Method according to any one of claims 1 to 7, **characterized in that** the first fixed filter threshold value (FT1) is set to zero.

9. Method according to any one of claims 1 to 8, **characterized in that** the second fixed filter threshold value (FT2) in case of contact is dynamically calculated as either percentage value of a found filter signal maximum or is chosen constant.

10. Method according to one of claims 1 to 9, **characterized in that** the filtering of the sensor signal (SS, SS') is carried out by means of the FIR filter (FIR) by storing the values of the sensor signal (SS, SS') in the memory cells of a ring memory and multiplying them by a set of weighting factors, and then summing the multiplication results.

## Revendications

1. Procédé de détermination d'un instant d'un toucher d'un élément capteur capacitif, sachant qu'une valeur de capacité de l'élément capteur est mesurée continuellement et est traitée en un signal de capteur numérique (SS), sachant que le signal de capteur (SS), détecté continuellement, passe par les étapes de procédé suivantes :
- Filtrage du signal de capteur (SS) au moyen d'un filtre numérique, de préférence d'un filtre FIR (FIR), qui présente un comportement passe-haut ou passe-bande et émet un signal de filtre (FS),
- constatation d'un commencement de dynamique, quand le signal de filtre (FS) dépasse vers le haut une première valeur de seuil (FT1) déterminée
- détermination, en tant qu'instant potentiel du toucher, de l'instant auquel le signal de filtre (FS) dépasse vers le bas une deuxième valeur de seuil de filtre (FT2) déterminée
- sortie de l'instant potentiel déterminé du toucher en tant qu'instant réel du toucher (BZ) de l'élément capteur capacitif quand le signal de capteur (SS), en ce qui concerne sa valeur avant le toucher prise en considération en tant que ligne zéro virtuelle, dépasse vers le haut une valeur de seuil de signal de capteur (ST1),
**caractérisé en ce que**,
le signal de filtre (FS) est continuellement intégré pour la reconstruction sans offset (RS) de l'évolution du signal de capteur (SS) et que l'instant potentiel déterminé du toucher est sorti en tant qu'instant réel du toucher (BZ) lorsque le signal de capteur reconstruit (RS) est situé à cet instant au-dessus de la valeur de seuil de signal de capteur (ST1).

2. Procédé selon la revendication 1, **caractérisé en ce que** le signal de capteur (SS) continuellement déterminé est sous-échantillonné, par moyennage sur plusieurs valeurs successives, à au moins un autre signal de capteur (SS'), et que le premier signal de capteur (SS) initial et l'au moins un autre signal de capteur (SS') sous-échantillonné passent respectivement par les mêmes étapes de procédé, dans des branches de procédé (1, 2) exécutées parallèlement.

3. Procédé selon revendication 1 ou 2, **caractérisé en ce qu'**une compensation de dérive du signal de capteur reconstruit (RS) est effectuée par l'intermédiaire d'un mécanisme de réglage, qui attend initialement le processus transitoire du filtre FIR (FIR), et que la compensation de dérive est arrêtée temporairement lorsqu'un début de dynamique est constaté.

4. Procédé selon l'une des revendications 1 à 3, **caractérisé en ce que** la sortie d'un autre instant de toucher (BZ) de l'élément capteur capacitif est bloquée jusqu'à l'achèvement du toucher et que l'achèvement du toucher est reconnu quand le signal de capteur reconstruit (RS) dépasse vers le bas une valeur de seuil de signal de capteur (ST2) déterminée en fonction d'une valeur maximale du signal de capteur reconstruit (RS).

5. Procédé selon l'une des revendications 2 à 4, **caractérisé en ce que**, après la sortie d'un instant de toucher (BZ) de l'élément capteur capacitif dans d'autres branches de procédé (1, 2), d'autres sorties / déclenchements sont empêchés pour la durée d'un temps de blocage (SZ).

6. Procédé selon la revendication 5, **caractérisé en ce que** le temps de blocage (SZ) est écoulé quand l'une des branches de procédé (1, 2) a reconnu l'achèvement d'un toucher.

7. Procédé selon l'une des revendications 1 à 6, **caractérisé en ce que** la valeur de capacité de l'élément capteur est mesurée au moyen d'un procédé d'intégration appliqué continuellement, dans lequel une tension (US), appliquée sur un condensateur d'intégration avec une valeur de capacité connue, est respectivement mesurée au moyen d'un convertisseur A/N (ADC) et traitée en un signal de capteur (SS) numérique.

8. Procédé selon l'une des revendications 1 à 7, **caractérisé en ce que** la première valeur de seuil de filtre (FT1) est mise à zéro.

9. Procédé selon l'une des revendications 1 à 8, **caractérisé en ce que** la deuxième valeur de seuil de filtre (FT2), en cas de toucher, est ou calculée dynamiquement en tant que valeur en pourcentage d'un maximum de signal de filtre trouvé ou sélectionnée constamment.

10. Procédé selon l'une des revendications 1 à 9, **caractérisé en ce que** le filtrage du signal de capteur (SS, SS') est effectué au moyen du filtre FIR (FIR), les valeurs du signal de capteur (SS, SS') étant mémorisées dans les cellules de mémorisation d'une mémoire circulaire et multipliées par un ensemble de facteurs de pondération, et les résultats de la multiplication étant ensuite totalisés.
